# EUROPÄISCHE PATENTSCHRIFT

(11) **EP 4 034 891 B1**
(45) Veröffentlichungstag und Bekanntmachung des Hinweises auf die Patenterteilung: **28.10.2026**
(21) Anmeldenummer: 20781334.6
(22) Anmeldetag: 24.09.2020
(51) Int. Cl.: G01R 27/16, G01R 19/25, H02J 3/00, H02J 13/12, H02J 13/13, G01R 23/16

(54) **VORRICHTUNG ZUR BESTIMMUNG DER IMPEDANZ IN ABHÄNGIGKEIT DER FREQUENZ EINES ZU MESSENDEN VERSORGUNGSNETZES**
APPARATUS FOR DETERMINING THE IMPEDANCE ON THE BASIS OF THE FREQUENCY OF A SUPPLY NETWORK TO BE MEASURED
APPAREIL DE DÉTERMINATION D'IMPÉDANCE SUR LA BASE DE LA FRÉQUENCE D'UN RÉSEAU D'ALIMENTATION À MESURER

(30) Priorität: 24.09.2019 DE 102019214533
(43) Veröffentlichungstag der Anmeldung: 03.08.2022
(73) Patentinhaber: Rheinisch-Westfälische Technische Hochschule (RWTH) Aachen, 52062 Aachen (DE)
(72) Erfinder: MONTI, Antonello, 52072 Aachen (DE); GURUMURTHY, Sriram Karthik, 52074 Aachen (DE); UHL, Robert, 52072 Aachen (DE); PITZ, Manuel, 52066 Aachen (DE)
(74) Vertreter: RCD-Patent Giesen, Schmelcher & Griebel Patentanwälte PartG mbB
(86) Internationale Anmeldenummer: PCT/EP2020/076779
(87) Internationale Veröffentlichungsnummer: WO 2021/058678

(56) Entgegenhaltungen:
- EP-A1- 3 301 777
- US-A1- 2014 032 147
- SHEN ZHIYU ET AL: "Small-signal impedance measurement in medium-voltage dc power systems", 2015 INTERNATIONAL CONFERENCE ON ELECTRICAL SYSTEMS FOR AIRCRAFT, RAILWAY, SHIP PROPULSION AND ROAD VEHICLES (ESARS), IEEE, 3 March 2015 (2015-03-03), pages 1 - 5, XP032774351, DOI: 10.1109/ESARS.2015.7101537
- ANTONINO RICCOBONO ET AL: "Noninvasive Online Parametric Identification of Three-Phase AC Power Impedances to Assess the Stability of Grid-Tied Power Electronic Inverters in LV Networks", IEEE JOURNAL OF EMERGING AND SELECTED TOPICS IN POWER ELECTRONICS, vol. 6, no. 2, 1 June 2018 (2018-06-01), Piscataway, NJ, USA, pages 629 - 647, XP055757727, ISSN: 2168-6777, DOI: 10.1109/JESTPE.2017.2783042

## Beschreibung

In den vergangenen Jahren ist ein zunehmender Trend zu komplizierten elektrischen Netzen festzustellen. Dies ist zum einen darin begründet, dass immer mehr elektrische Verbraucher an solche Netze angeschlossen werden als auch darin, dass die Zahl der Quellen, die in elektrische Netze speisen, durch die zunehmende Anzahl von Energie-Erzeugern aus regenerativen Quellen zunimmt.

Dabei ist auch eine zunehmende Komplexität feststellbar. Waren am Ende des letzten Jahrtausends eine kleine Zahl von Kraftwerken auf einer relativ hohen Ebene der Netztopologie (Transportnetz) angesiedelt und die Verbraucher im Wesentlichen auf unteren Ebenen, so ist durch die sogenannte Energiewende eine zunehmende Anzahl von Energie-Erzeugern auf einer unteren Ebene der Netztopologie zu finden.

Sowohl auf Seiten der Energieerzeugung als auch Seiten der Verbraucher sind dabei elektronische Schaltungen mit frequenz-gesteuerter Leistungselektronik anzutreffen.

Waren in klassischen Netzen alleine die Netzfrequenz bestimmend, ist nunmehr festzustellen, dass diese Vielzahl von elektronischen Schaltungen mit frequenz-gesteuerter Leistungselektronik sich gegenseitig beeinflussen und aufeinander in unterschiedlichem Maß rückkoppeln.

Insbesondere im Fall von Invertern und Wandlern ist festzustellen, dass deren (Eingangs- und/oder Ausgangs-) Impedanzen einen negativen inkrementellen Widerstand aufweisen. Werden mehrere zusammengeschaltet, so kann das Versorgungsnetz instabil werden. Man bezeichnet dies auch als harmonische Instabilität.

Dies kann z.B. darin begründet sein, dass die Bandbreiten der Regelung hoch sind, Nicht-Linearitäten durch Phasen-Regel-Schleifen eingeführt werden, Impedanzüberschneidungen (im Bode-Diagramm) und die Parallelresonanzen (z.B. von parallel-geschalteten Invertern), die die Wahrscheinlichkeit für eine durch Harmonische induzierte Instabilität im Netz steigern.

In der Vergangenheit wurden daher bereits erste Ansätze unternommen die frequenzabhängige Impedanz eines Versorgungsnetzes zu bestimmen.

Ein erster Ansatz basiert auf einem Netzwerkanalysator, der die Impedanz online bestimmt. Ein solcher Ansatz ist z.B. im Artikel "Wide-Band Impedance Measurement for converter impedance determination in LV-Grids," in 2018 20th European Conference on Power Electronics and Applications (EPE'18 ECCE Europe), 2018, Seite P-1 der Autoren M. Bienholz and G. Griepentrog beschrieben.

Dabei wird mittels einer ersten Vorrichtung die sogenannten "differential mode impedance" bestimmt und mit einer zweiten Vorrichtung die sogenannte "common mode impedance". Die Vorrichtung besteht dabei aus einem Netzwerkanalysator, einem Leistungsverstärker, einem isolierenden Transformator und ausgangsseitigen Filtern gegen Störstrahlung (Elektromagnetische Interferenz / elektromagnetische Verträglichkeit). Der Leistungsverstärker ist dabei auf die Bereitstellung einer gesonderten Gleichspannung angewiesen.

Die Anschlüsse der Vorrichtung werden ausgangsseitig (d.h. nach den Filtern) an einen Leistungskreis angeschlossen, bei dem die Impedanz zu messen ist. Mittels einer sinusförmigen Frequenzabtastung von einer unteren Frequenz bis zu einer oberen Frequenz wird der Kreis abgetastet. Das Signal muss dabei durch den Leistungsverstärker verstärkt werden. Die auftretende Spannung bzw. der auftretende Strom am Ausgang werden gemessen und die Impedanz kann hieraus bestimmt werden.

Dieser Ansatz erweist sich jedoch aus vielerlei Hinsicht als nachteilig. So ist die vorgestellte Lösung auf die Bereitstellung eines Netzwerkanalysators nebst weiteren Elementen aufgewiesen. Insbesondere die Bereitstellung von Leistungstransformatoren als auch Leistungsverstärkern erhöht das Gewicht der Anlage und auch die Kosten. Zudem erfordert der Leistungsverstärker eine eigene Spannungsversorgung, die ebenso zu den Kosten als auch dem Gewicht beiträgt. Hieraus ergibt sich aber auch, dass ein solches Gerät nicht im Plug&Play-Betrieb verwendet werden kann. Zudem erlaubt das Verfahren nur eine langsame Messung, denn die Frequenzen müssen einzeln abgetastet werden. Dies ist für die sich schnell ändernde Umgebungen ungeeignet, da die Messintervalle für eine vollständige Messung meist erheblich höher sind als die Rate der Änderung. D.h., die Messung kann das Geschehen nicht richtig abbilden.

Ein anderer Ansatz ist aus den Aufsätzen "Online network impedance identification with wave-package and inter-harmonic signals," der Autoren M. Jordan, F. Grumm, H. Langkowski, T. Do Thanh, and D. Schulz, in Nonsinusoidal Currents and Compensation (ISNCC), 2015 International School on, 2015, Seite 1-6., und "Novel Grid Impedance Measurement Setups in Electrical Power Systems," der Autoren D. S. T. T. Do, M. Jordan, H. Langkowski, ppl. Meas. Power Syst. (AMPS), 2016 IEEE Int. Work. bekannt. Dabei wird ein Vollbrückengleichrichter (1-phasig / 3-phasig) verwendet. Auf der gleichgerichteten Seite der Schaltung wird eine definierte Last in Serie mit einem IGBT-Transistor bereitgestellt. Parallel zum Transistor ist ein passives RC-Dämpfungsglied geschaltet.

Mit dem vorstehend beschriebenen Gerät kann ein Lastwiderstand geschaltet werden, um das Versorgungsnetz zu stören, wobei hier eine großsignalartige Störung verwendet wird. Dieses Verfahren wird auch als transientes Verfahren bezeichnet.

Beispielsweise kann der IGBT -Transistor mit einer Periode von 80 ms und einem Tastverhältnis von 0,5 geschaltet werden. Damit fließt durch den Lastwiderstand Strom entprechend 2 Zyklen eines (europäischen) Wechselstromnetzes. In den jeweiligen An bzw. Aus-Perioden wird die Spannung bestimmt. In einem AN-Zyklus wird auch der Strom bestimmt, da in einem AUS-Zyklus kein Strom fließt. Mittels einer zeitdiskreten Fouriertranformation werden die zeitbasierten Werte transformiert und anschließend wird die Netzimpdanz für die Netzfrequenz (in Europa 50 Hz) bestimmt. Diese Technik wird auch als Wave-Packet-Technik bezeichnet.

Alternativ kann mittels der Vorrichtung auch ein alternatives Verfahren benutzt werden, das als InterHarmonischen-Technik bezeichnet wird. Dabei wird ein interharmonisches Modulationssignal an den IGB Transistor angelegt. Z. B. kann der Transistor mit 150 Hz und 200 Hz geschaltet werden. Wenn man einen idealen Mess- und Berechnungsprozess zu Grunde legen könnte, könnte die Impedanz an den interharmonischen Frequenzen bestimmt werden. Die Impedanz in Bezug auf andere Frequenzen könnte extrapoliert werden.

Auch diese Vorgehensweise hat Nachteile. Entweder wird die Messung nur bei einer Frequenz vorgenommen, dann ist das Gerät gänzlich ungeeignet Impedanzen über ein größeres Spektrum zu bestimmen. Oder aber durch die Einbringung groß-signalartiger Störungen wird das Netz transient stark belastet. Solche Großsignal-basierten Verfahren sind zudem leistungshungrig und erzeugen eine erhebliche Wärme im Lastwiderstand, die sicher abgeführt werden muss. Zudem lässt sich aus den so ermittelten Werten kein sicheres Kriterium für eine Netzwerkstabilität ermitteln.

Aus der europäischen Patentanmeldung EP 3 301 777 A1 ist ein Inverter bekannt, der es erlaubt die Netzstabilität zu erkennen. Dabei wird zum Ermitteln der Netzanschlussstabilität eine erste und eine zweiten Stromsequenz eingespeist, die Netzspannung und der Netzstrom für jede Sequenz gemessen und eine Ersatzimpedanzmatrix des Stromnetzes ermittelt, welche dann zum Bestimmen der Erfüllung einer Stabilitätsanforderung benutzt wird. Aus der US Patentanmeldung US 2014 / 032 147 A1 ist eine Verfahren zur

Impedanzmessung mithilfe der Injektion eines Chirp-Signals bekannt. Aus der Schrift "Small-signal impedance measurement in medium-voltage dc power systems" der Autoren SHEN ZHIYU ET AL, veröffentlicht in 2015 INTERNATIONAL CONFERENCE ON ELECTRICAL SYSTEMS FOR AIRCRAFT, RAILWAY, SHIP PROPULSION AND ROAD VEHICLES (ESARS), IEEE, (20150303), doi:10.1109/ESARS.2015.7101537, Seiten 1-5 ist eine weitere Vorrichtung zur Impdeanzmessung bekannt.

### Aufgabe

Ausgehend hiervon ist es eine Aufgabe der Erfindung eine verbesserte Vorrichtung anzugeben, mit der die Stabilität eines Netzes abgeschätzt werden kann.

### Kurzdarstellung der Erfindung

Die Aufgabe wird gelöst durch eine Vorrichtung gemäß Anspruch 1. Weitere vorteilhafte Ausgestaltungen sind Gegenstand der abhängigen Ansprüche, der Beschreibung und der Figuren.

### Kurzdarstellung der Figuren

Nachfolgend wird die Erfindung näher unter Bezug auf die Figuren erläutert. In diesen zeigt:
Fig. 1 ein allgemein ein verallgemeinertes Versorgungsnetz zur Erläuterung der Erfindung,
Fig. 2 ein Ersatzschaltbild für ein Quellen-Last-System zur Verdeutlichung der Erfindung,
Fig. 3 ein Ersatzschaltbild mit äquivalenten Impedanzen zur Verdeutlichung der Erfindung,
Fig. 4 eine schematische Darstellung von Ausführungsformen von Elementen gemäß der Erfindung, und
Fig. 5 eine schematische Darstellung der Verwendung eines erfindungsgemäßen Gerätes in einem Niederspannungsnetz.

### Ausführliche Darstellung der Erfindung

Nachfolgend wird die Erfindung eingehender unter Bezugnahme auf die Figuren dargestellt. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden, soweit nicht explizit als reine Alternative dargestellt.

Weiterhin wird nachfolgend der Einfachheit halber in aller Regel immer nur auf eine Entität Bezug genommen werden. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Soweit nachfolgend Verfahren beschrieben werden, sind die einzelnen Schritte eines Verfahrens in beliebiger Reihenfolge anordenbar und/oder kombinierbar, soweit sich durch den Zusammenhang nicht explizit etwas Abweichendes ergibt. Weiterhin sind die Verfahren - soweit nicht ausdrücklich anderweitig gekennzeichnet - untereinander kombinierbar.

Angaben mit Zahlenwerten sind in aller Regel nicht als exakte Werte zu verstehen, sondern beinhalten auch eine Toleranz von +/- 1% bis zu +/- 10 %.

Bezugnahme auf Standards oder Spezifikationen oder Normen sind als Bezugnahme auf Standards bzw. Spezifikationen bzw. Normen, die zum Zeitpunkt der Anmeldung und/oder soweit eine Priorität beansprucht wird - zum Zeitpunkt der Prioritätsanmeldung gelten / galten zu verstehen. Hiermit ist jedoch kein genereller Ausschluss der Anwendbarkeit auf nachfolgende oder ersetzende Standards oder Spezifikationen oder Normen zu verstehen.

In den Figuren ist jeweils eine Seitenansicht dargestellt. Soweit nicht anders vermerkt beziehen sich nachfolgend alle Beschreibungen immer auf alle Ausführungsformen.

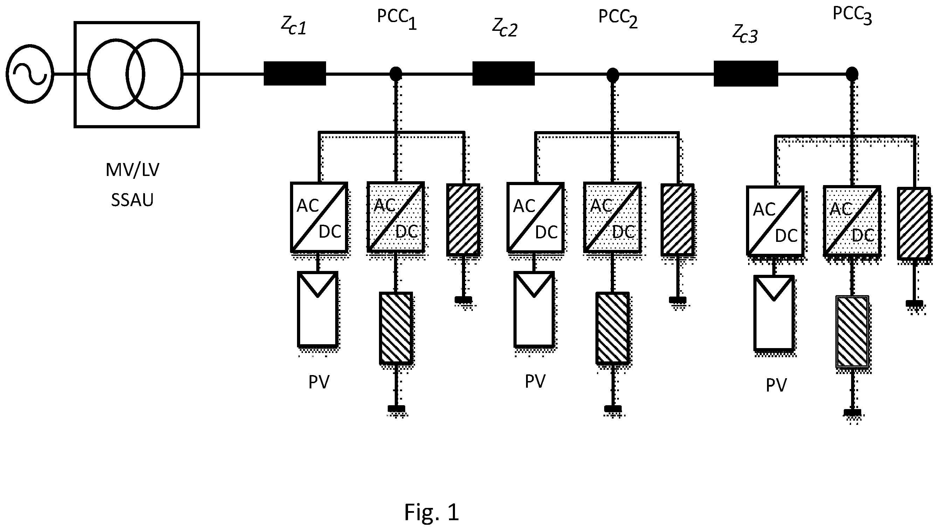

Fig. 1 zeigt ein verallgemeinertes Versorgungsnetz zur Erläuterung der Erfindung. Beispielhaft wird hier Bezug auf ein Niederspannungsnetz genommen. Ein Niederspannungsnetz ist dadurch gekennzeichnet, dass es Versorgungsspannungen für typische Haushaltsgegenstände / Maschinen zur Verfügung stellt. D.h. in einem europäischen Niederspannungsnetz ist mit Spannungen von etwa 230 Volt in einem einphasigen Netz bzw. 400 Volt in einem dreihäusigen Netz auszugehen. Allgemeiner können alle Versorgungsnetze mit einer Spannung von 1000 Volt oder weniger als Niederspannungsnetz im Folgenden verstanden werden.

Das beispielhaft betrachtete Niederspannungsnetz (NV) wird mittels eines Transformators an ein Mittelspannungsnetz (MV) angebunden. Die einzelnen Leitungsabschnitte zum Knoten PCC₁ bzw. zwischen den Knoten PCC₁ PCC₂, PCC₃ weisen eine Impedanz Z_{c1}, Z_{c2}, Z_{c3} auf. An den Knoten ist beispielhaft je eine weitere Quelle - dargestellt als Photovoltaikanlage PV- über einen Wandler DC/AC an den jeweiligen Knoten angebunden. Weiterhin ist an jedem Knoten eine Schaltlast wiederum über einen Wandler DC/AC angebunden. Ebenso ist eine weitere Last ohne Wandler direkt an jeden Knoten angebunden.

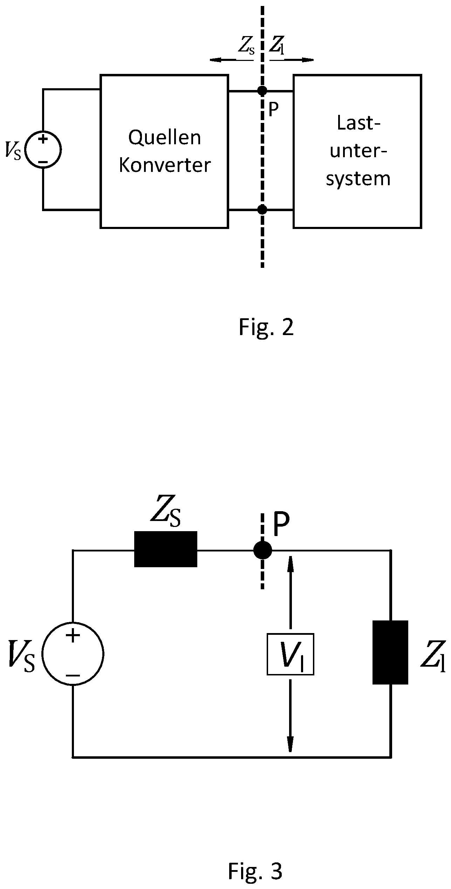

Um die Stabilität eines solchen Netzes und insbesondere eines daran angeschlossen Wandlers AC/DC zu untersuchen kann das Ersatzschaltbild nach Figur 2 bzw. Figur 3 verwendet werden. Dabei kann durch Bestimmung des Verhältnisses aus breitbandiger frequenzabhängiger Impedanz (engl. wideband-frequency impedance, abgekürzt WFI) des Wandlers AC/DC und des Netzes ein Kriterium für die Stabilität ermittelt werden. Während die WFI eines Wandlers beispielsweise durch den Hersteller bereitgestellt (durch Messung, Simulation, theoretische Analyse etc.) werden kann, ist die WFI des Netzes nicht oder nur unter großen Anstrengungen analytisch darstellbar. Dies liegt unter anderem daran, dass viele Komponenten nicht ohne weiteres zugänglich bzw. ihre Parameter unbekannt sind. Dies trifft in aller Regel auf die Kabel und die Verbindung der Kabel, Transformatoren als auch weitere (unbekannte) Wandler zu. Zudem sind Netzwerke nicht statisch, sondern ändern z.B. durch Inbetriebnahme / Außerbetriebnahme von Geräten ständig ihre Eigenschaften.

Mittels der Erfindung wird es möglich. die WFI des Verbrauchsnetzes an irgendeiner Stelle im elektrischen Netz zu bestimmen. Hierdurch wird es ermöglicht, dass die Stabilität des Netzes bestimmt wird. Diese Information kann durch ein Gerät, z.B. ein Wandler AC/DC am benachbarten Knoten und/oder den Netzbetreiber dazu verwendet werden, um Maßnahmen zur Stabilitätserhöhung zu treffen. Die Information kann über eine geeignete (getrennte) drahtlose oder drahtgebundene Schnittstelle oder aber über eine geeignete Modulation über das Stromnetz transportiert werden. Beispielsweise können die Informationen aus einem Niederspannungsnetz an das Automatisierungssystem des Netzes (engl. Secondary Substation Automation Unit, abgekürzt SSAU) weitergeleitet werden und dort zentralisiert erfasst werden. Werden die WSI Daten gesammelt kann hieraus für das überwachte Netz die Stabilität desselben bestimmt werden.

D.h., die Erfindung schlägt erstmalig eine Plug&Play-fähige Vorrichtung vor, die es ermöglicht in Echtzeit die Impedanz breitbandig zu messen. Anders als in bisherigen Einrichtungen wird dabei das Netz nicht durch großsignalartige Störungen belastet oder durch eine unnötige Leistungsaufnahme belastet. Die Vorrichtung ist dabei für sowohl Niederspannungs- als auch Mittelspannungsnetze (≤ 60 kV) geeignet.

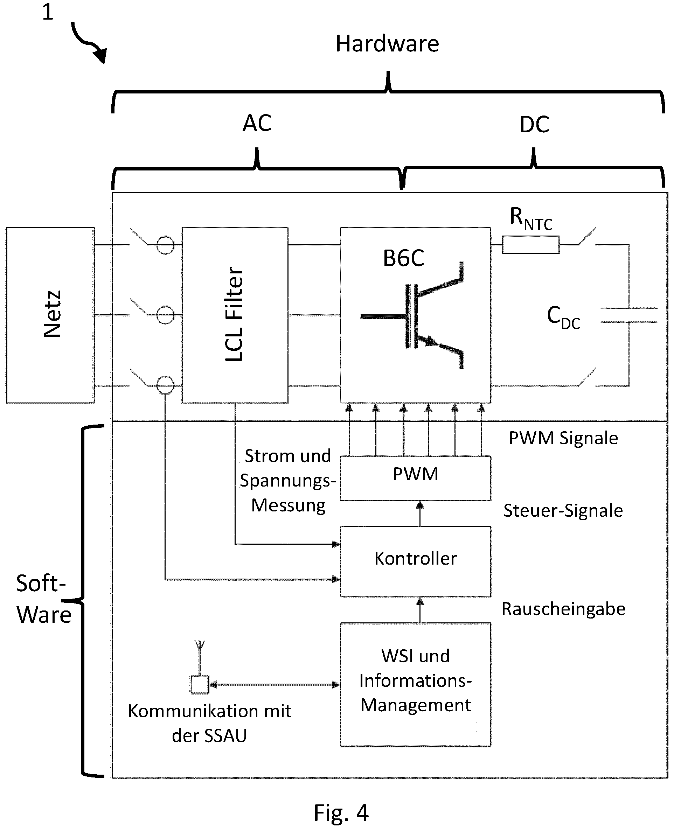

Fig. 4 zeigt eine schematische Darstellung von Ausführungsformen von Elementen gemäß der Erfindung.

Eine erfindungsgemäße Vorrichtung 1 zur Bestimmung der Impedanz in Abhängigkeit der Frequenz eines zu messenden Versorgungsnetzes weist eine Energiespeichereinheit auf, welche geeignet ist in einer Aufladephase, welche einer Messphase vorhergeht, Energie aus dem zu messenden Versorgungsnetz zu beziehen.

Weiterhin weist eine erfindungsgemäße Vorrichtung 1 eine Messeinheit auf, welche geeignet ist, ein breitbandiges Messsignal in das zu messende Versorgungsnetz einzuspeisen.

Das breitbandige Messsignal ist dabei von geringer Stärke, sodass es nicht zu einer großsignalartigen Störung (transiente Störung) führt. Basierend auf dem Messsignal wird die breitbandige frequenzabhängige Impedanz bestimmt.

In der Messphase bezieht die Energiespeichereinheit keine Energie aus dem zu messenden Versorgungsnetz.

D.h., anders als in bisherigen Einrichtungen kann der Energieeigenbedarf die Messung nicht mehr stören.

Beispielsweise kann ein geringer Strom von wenigen Ampere, z.B. ^{~} 1 Ampere mit einem aufgeprägten Messsignal verwendet werden. Das aufgeprägte Messsignal kann auf andere kleinsignalige Störgrößen hin ausgerichtet sein, sodass es sicher erfasst werden kann.

Wie aus Figur 4 ersichtlich kann die Vorrichtung einen Hardware-Anteil als auch einen Software-Anteil aufweisen, wobei Software auch in Hardware implementiert sein kann.

Die Vorrichtung 1 in Figur 4 ist für ein dreiphasiges Wechselstrom-Netz geeignet. Andere Netze können mit der Vorrichtung gemäß Figur 4 oder speziell hierauf zugeschnitten Vorrichtungen gemessen werden.

In Figur 4 weist die Vorrichtung 1 einen 3-phasigen Wandler in B6C-Technologie, sowie Leistungselektronikschalter auf. Die Leistungselektronikschalter können beispielsweise als IGBTs oder als MOSFETs implementiert sein, wobei der Fachmann hier die Wahl z.B. anhand der zu erwartenden Spannungen als auch der gewünschten (maximalen) Schaltfrequenzen treffen kann. Auf der Gleichstromseite des Wandlers ist ein Widerstand mit negativem thermischen Koeffizienten R_{NTC}, mindestens ein Relaisschalter und ein Kondensator C_{DC} angeordnet.

Auf der Wechselspannungsseite des Wandlers kann ein LCL Filter und ebenso ein Relaisschalter angeordnet sein. Filter mit einer anderen geeigneten Topologie, wie LC Filter, sind auch denkbar.

Auf der Softwareseite kann ein Kontroller angeordnet sein. Der Kontroller kann z.B. ein Stromkontroller oder ein nicht-linearer Kontroller sein. Der Kontroller kann Steueranweisungen erzeugen, mit denen der Pulsweitenmodulationsblock PWM angesteuert wird. Der Pulsweitenmodulationsblock PWM wiederum steuert die Leistungselektronikschalter im Wandler B6C.

Der Kontroller baut dabei auf der Messung von eingeprägtem Netzstrom, Netzspannung und der Spannung am Kondensator C_{DC} im Gleichspannungsteil auf.

Ein Breitbandsystemidentifikations- und Informationsmanagement-Block WSI interagiert mit dem Kontroller.

Der Breitbandsystemidentifikations- und Informationsmanagement-Block WSI kann in Ausführungsformen der Erfindung auch über Kommunikationseigenschaften, z.B. mit einer SSAU, verfügen, um die ermittelten WFI-Daten des Netzes weiterzugeben.

Im Betrieb wird in einer Aufladephase zunächst der Kondensator C_{DC} im Gleichspannungsteil durch Schließen der DC-seiteigen Relaisschalter aufgeladen. Ein optionaler Widerstand R_{NTC} begrenzt zunächst den Strom in einer Startphase. Während der Aufladephase wird der B6C Wandler als Brückengleichrichter verwendet.

In einer zweiten Phase, der Messphase, wird die im Kondensator C_{DC} gespeicherte Energie in das Netz zurück gespeist. D.h. der B6C Wandler wird als Wechselrichter angesteuert. Während der Messphase injiziert der WSI Block ein breitbandiges Messsignal. Dies kann z.B. dadurch realisiert sein, dass die Stromreferenz des B6C Wandler entsprechend angesteuert wird. Bei einem Wechselspannungsnetz kann die Messphase z.B. wenigen Zyklen der Netzfrequenz entsprechen, z.B. 2 Zyklen, entsprechend 40 ms in einem europäischen Wechselspannungsnetzwerk. Während der Messphase werden Spannung und Strom gemessen und die entsprechenden Werte werden dem Kontroller zugeführt. Die Werte können dann geeignet weiterverarbeitet werden. Die Wahl der Dauer des Messzyklus korreliert mit dem auflösbaren Frequenzspektrum.

Beispielsweise können die Werte in einen first-in-first-out (FIFO) Pufferspeicher eingegeben werden. Mittels schneller Fourier-Transformation (FFT) können die Werte in das Frequenzspektrum überführt werden. Dort kann mittels Systemidentifikation die WFI Übertragungsfunktion bestimmt werden. Die WFI-Messung kann je nach Anforderung z.B. in der d/q-Domäne (direct-quadrature (DQ) domain) oder einer anderen Domäne vorgenommen werden.

Beispielsweise kann eine Kurvenfit-Technik verwendet werden. Hierdurch kann sich auch ein Vorteil bei der Datenspeicherung ergeben.

Hieraus kann durch den Kontroller (oder durch eine andere Einrichtung) ein Stabilitätskriterium bestimmt werden, indem z.B. Impedanz-basierte Stabilitätsbestimmungstechniken verwendet werden. Solche Techniken sind z.B. aus dem Artikel "Noninvasive Online Parametric Identification of Three-Phase AC Power Impedances to Assess the Stability of Grid-Tied Power Electronic Inverters in LV Networks," der Autoren A. Riccobono and A. Monti, veröffentlicht in IEEE J. Emerg. Sel. Top. Power Electron., vol. 6, no. 2, pp. 629-647 und "Impedance measurement of three phase systems in DQ-domain: Applying MIMO-identification techniques," der Autoren T. Roinila, T. Messo, and A. Aapro, veröffentlichtin 2016 IEEE Energy Conversion Congress and Exposition (ECCE), Milwaukee, WI, 2016, bekannt.

Die Vorrichtung 1 kann dann z.B. den identifizierten WFI Koeffizienten und das hieraus ermittelte Stabilitätskriterium an andere Einrichtungen, z.B. SSAU weiterleiten, sodass korrigierende Maßnahmen ergriffen werden können.

Da die Vorrichtung 1 im Wesentlichen die Energie zurückspeist, die sie zuvor aufgenommen hat - die zur Messung, Berechnung und Ansteuerung benötigte Energie fällt dabei kaum ins Gewicht - benötigt die Vorrichtung 1 gemäß der Erfindung keine zusätzliche Spannungsversorgung. D.h. die Vorrichtung 1 kann aus dem zu messenden Netz gespeist werden. Da das Messsignal lediglich eine geringe Größe aufweist, muss die Vorrichtung nicht auf hohe Ströme ausgelegt sein.

In Ausführungsformen der Erfindung weist das breitbandige Messsignal ein binäres Signal auf, welches das Spektrum eines geeigneten Rauschens approximiert, beispielsweise das Spektrum des weißen Rauschens. In Ausführungsformen der Erfindung weist das breitbandige Messsignal ein binäres Signal auf, das durch einen deterministischen Zufallsgenerator erzeugt wird.

Die Messphase kann - wie zuvor schon angedeutet - geeignet gewählt sein. Es besteht dabei keine Notwendigkeit sich auf das Vielfache einer eventuellen Netzperiode zu beschränken.

Allgemein gilt, dass die Messphase von der Schaltfrequenz/Abtastrate f_{sw} des Wandlers B6C, der Anzahl M von Signalperioden des Messignales PBRS und der Anzahl von bis N des PRBS Schieberegisters abhängt. Die Messphase ist dann bestimmt durch ${T}_{inj} = \frac{M ⋅ \left({2}^{N}-1\right)}{{f}_{sw}}$.

D.h. durch Anpassung der Parameter M als auch N als auch f_{sw} kann die Impedanzmessung an unterschiedliche Umgebungen angepasst werden, z.B. an ein Signal/Rausch-Verhältnis.

In einer Ausführungsform der Erfindung weist das Messsignal Frequenzkomponenten von mehr als 24,42 Hz auf. D.h., wenn die minimale Frequenz 24,42 Hz aufweist, so können die weiteren Frequenzkomponenten ein Vielfaches davon aufweisen.

In einer Ausführungsform der Erfindung weist das Messsignal Frequenzkomponenten von weniger als 50 kHz auf. D.h., wenn die maximale Abtastrate 50 kHz aufweist, so kann nach dem Nyquist-Shannon Theorem dies für Messungen bis 25 kHz verwendet werden.

Die Frequenzauflösung ergibt sich aus der diskreten Fouriertranformation zu $Δ f = \frac{{f}_{sw}}{M ⋅ \left({2}^{N}-1\right)}$.

Entpechenderweise ergibt sich als höchste Frequenz für die Impedanzbestimmung gemäß Nyquist-Shannon Theorem ${f}_{max} = \frac{{f}_{sw}}{2}$.

Ohne Beschränkung der Allgemeinheit kann die Vorrichtung 1 in Niederspannungsnetzen, Mittelspannungsnetzen als auch Hochspannungsnetzen Verwendung finden.

In Ausführungsformen der Erfindung weist die Vorrichtung 1 weiterhin eine Auswerteeinheit auf, die geeignet ist aus der gemessenen frequenzabhängigen Impedanz ein Stabilitätskriterium abzuleiten.

In Ausführungsformen der Erfindung weist die Vorrichtung 1 weiterhin eine Fernmeldeeinheit auf, die geeignet ist, Daten, welche auf der bestimmten frequenzabhängigen Impedanz basieren, oder die Impedanz selbst zur Verfügung zu stellen.

In Ausführungsformen der Erfindung wird eine als Wideband System Identification (WSI) Technik verwendet. Bei dieser Technik wird ein Rauschsignal, z.B. ein PRBS Signal (Abkürzung für Pseudorandom binary sequence) injiziert. Typischerweise wird dafür über einen bestimmten Zeitraum, z.B. einen vollen Zyklus einer Wechselspannung, die Spannungs- oder Stromreferenz mit dem PRBS Signal beaufschlagt.

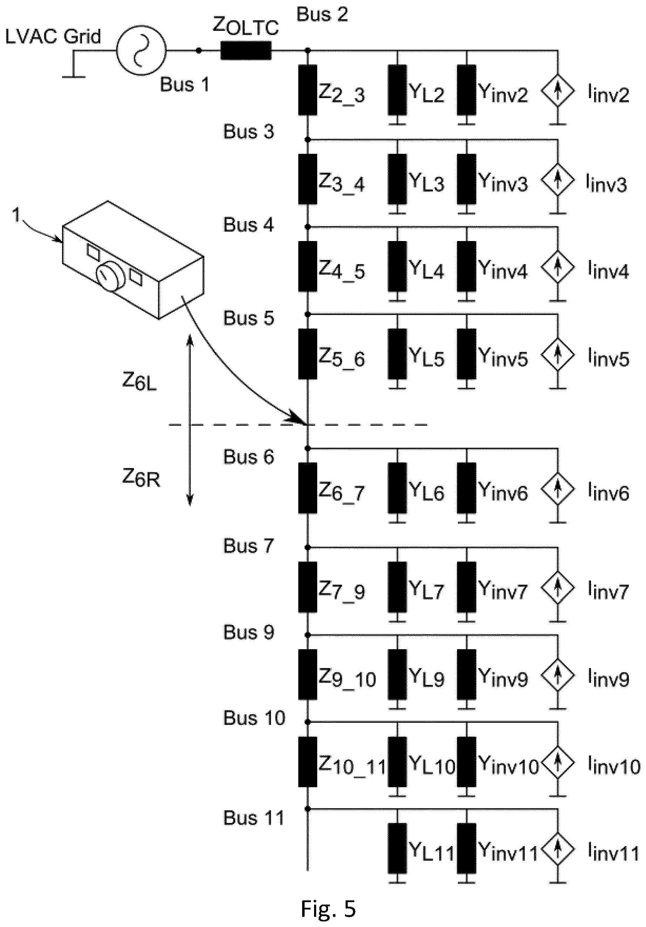

Eine Verwendung der Vorrichtung 1 ist in Figur 5 gezeigt. Dabei wird ein Niederspannungsverteiler mit einer Anzahl von Strängen "Bus" angenommen. Nunmehr soll am Bus 6 die Stabilität / die Stabilitätsgrenzen bestimmt werden.

Nunmehr wird die Vorrichtung 1 an den Bus 6 angeschlossen und eine Messung - wie zuvor skizziert - vorgenommen. D.h., es werden durch den WSI Block mittels des PRBS Störungen im Strom bzw. der Spannung eingebracht. Die Spannung am entsprechenden Knotenpunkt wird wie durch die gestrichelte Linie gezeigt gemessen. Ebenso kann der Strom zu beiden Seiten der gestrichelten Linie bestimmt werden. Somit ist es möglich, das WFI auf beiden Abschnitten des Niederspannungsverteilers Z_{6L} und Z_{6R} in Bezug auf den Knotenpunkt, an dem die Vorrichtung 1 angeschlossen ist, zu messen. Basierend auf den WFIs kann nunmehr die Stabilität / die Stabilitätsgrenzen bestimmt werden.

Da die Vorrichtung 1 als Plug&Play-Einrichtung konzipiert ist, kann sie ohne Unterbrechung an ein laufendes Netz angeschlossen werden. Dabei kann die Messung am laufenden Netz vorgenommen werden. D.h. das Netz stellt nicht irgendeinen Kunstzustand dar, sondern es kann an einem realen Netz gemessen werden. Da die eingebrachten Störungen kleinsignalig sind, kann das Netz auch insbesondere in belastetem Zustand ausgemessen werden.

Es sei angemerkt, dass die Vorrichtung 1 auch dauerhaft am Netz verbleiben kann. Messungen können einmalig oder mehrmalig vorgenommen werden. Dabei können Messungen Event-gesteuert oder periodisch, z.B. alle 30 Sekunden, jede Minute, ... vorgenommen werden. Ebenso können Messwerte oder daraus abgeleitete Daten gespeichert und für spätere Auswertungen vorgehalten werden.

Ohne Beschränkung der Allgemeinheit kann die Vorrichtung 1 auch über eine geeignete Schnittstelle drahtlos oder drahtgebunden ferngesteuert werden.

Zusätzlich können die Messeinrichtungen außerhalb der Messphase auch für normale Spannungs- / Strom-Messungen verwendet werden.

Wird mittels Kurvenfit-Technik eine Übertragungsfunktion bestimmt, kann das Datenvolumen reduziert werden, denn für die Darstellung der DQ WFI Matrizen für den in Figur 5 diskutierten Abschnitt des Versorgungsnetzes würden in etwa 100 Gleitkommazahlen benötigt werden.

Mittels der Erfindung können die Probleme aus dem Stand der Technik vermieden werden. Insbesondere erlaubt es die Erfindung die Impedanz eines zu untersuchen Netzwerkes breitbandig zu messen.

Dabei ist es bei der Erfindung nicht nötig eine besondere Speisung der Vorrichtung vorzusehen. Dennoch ist die Vorrichtung kostengünstig und leicht und erlaubt damit die Messfunktion als Plug&Play-Vorrichtung zur Verfügung zu stellen. Damit wird der Einsatz erheblich vereinfacht.

Durch die Verwendung von (bandbegrenztem) (weißen) Rauschpulsen, sogenannten Bursts, welche in das zu untersuchende Netz eingespeist werden, kann die Impedanz des Netzwerkes über einen weiten Frequenzbereich bestimmt werden. Dabei kann die Messzeit geringgehalten werden und gegenüber dem Stand der Technik stark verringert werden.

Ohne Beschränkung der Allgemeinheit kann die dynamische Stabilität damit an jeder Stelle des Netzes, insbesondere an jeder Stelle des Niederspannungsnetzes (NV) als auch des Mittelspannungsnetzes (MV) bestimmt werden.

## Patentansprüche

1. Vorrichtung (1) zur Bestimmung der Impedanz in Abhängigkeit der Frequenz eines zu messenden dreiphasigen Wechselstrom-Versorgungsnetzes, aufweisend
• Eine Energiespeichereinheit, welche dazu eingerichtet ist in einer Aufladephase, welche einer Messphase vorhergeht, Energie aus dem zu messenden Versorgungsnetz zu beziehen,
• Eine Messeinheit, welche geeignet ist, ein Messsignal in das zu messende Versorgungsnetz einzuspeisen,
• Wobei in der Messphase die Energiespeichereinheit dazu eingerichtet ist keine Energie aus dem zu messenden Versorgungsnetz zu beziehen, **dadurch gekennzeichnet, dass**
∘ das Messsignal breitbandig ist und basierend auf dem Messsignal die frequenzabhängige Impedanz breitbandig bestimmt wird, dass
• das Messsignal Frequenzkomponenten von mehr als 24,42 Hz aufweist als auch, dass
• das Messsignal Frequenzkomponenten von weniger als 50 kHz aufweist,
• wobei die Vorrichtung eine Plug&Play Vorrichtung ist,
∘ wobei die Vorrichtung ohne Unterbrechung an ein laufendes Netz angeschlossen und auch eine Messung am laufenden Netz vorgenommen werden kann.

2. Vorrichtung (1) nach Anspruch 1, **dadurch gekennzeichnet, dass** das breitbandige Messsignal ein binäres Signal aufweist, welches das Spektrum eines weißen Rauschens approximiert.

3. Vorrichtung (1) nach Anspruch 1 oder 2, **dadurch gekennzeichnet, dass** das breitbandige Messsignal ein binäres Signal aufweist, das durch einen deterministischen Zufallsgenerator erzeugt wird.

4. Vorrichtung (1) nach einem der vorhergehenden Ansprüche, **dadurch gekennzeichnet, dass** die Messphase 40 ms oder weniger beträgt.

5. Vorrichtung (1) nach einem der vorhergehenden Ansprüche, **dadurch gekennzeichnet, dass** die Vorrichtung weiterhin eine Auswerteeinheit aufweist, die geeignet ist aus der gemessenen frequenzabhängigen Impedanz ein Stabilitätskriterium abzuleiten.

6. Vorrichtung (1) nach einem der vorhergehenden Ansprüche, **dadurch gekennzeichnet, dass** die Vorrichtung weiterhin eine Fernmeldeeinheit aufweist, die geeignet ist, Daten, welche auf der bestimmten frequenzabhängigen Impedanz basieren, oder die Impedanz selbst, zur Verfügung zu stellen.

## Claims

1. An apparatus (1) for determining the impedance on the basis of the frequency of a three-phase alternating current supply network to be measured, having
• an energy storage unit which is designed to draw energy from the supply network to be measured in a charging phase which precedes a measuring phase,
• a measuring unit which is suitable for feeding a measurement signal into the supply network to be measured,
• wherein in the measuring phase the energy storage unit is designed not to draw any energy from the supply network to be measured,
**characterized in that**
• the measurement signal is wideband and the frequency-dependent impedance is determined over a wideband range on the basis of the measurement signal,
**in that**
• the measurement signal has frequency components of more than 24.42 Hz, and **in that**
• the measurement signal has frequency components of less than 50 kHz,
• wherein the apparatus is a plug and play apparatus,
• wherein the apparatus can be connected without interruption to a running network and a measurement can also be undertaken on the running network.

2. The apparatus (1) according to Claim 1, **characterized in that** the wideband measurement signal has a binary signal which approximates the spectrum of white noise.

3. The apparatus (1) according to Claim 1 or 2, **characterized in that** the wideband measurement signal has a binary signal which is generated by a deterministic random generator.

4. The apparatus (1) according to one of the preceding claims, **characterized in that** the measuring phase is 40 ms or less.

5. The apparatus (1) according to one of the preceding claims, **characterized in that** the apparatus also has an evaluation unit which is suitable for deriving a stability criterion from the measured frequency-dependent impedance.

6. The apparatus (1) according to one of the preceding claims, **characterized in that** the apparatus also has a telecommunications unit which is suitable for providing data based on the determined frequency-dependent impedance, or the impedance itself.

## Revendications

1. Dispositif (1) de détermination de l'impédance en fonction de la fréquence d'un réseau d'alimentation en courant alternatif triphasé à mesurer, comportant
• une unité d'accumulation d'énergie, laquelle est agencée pour percevoir de l'énergie du réseau d'alimentation à mesurer dans une phase de charge, laquelle précède une phase de mesure,
• une unité de mesure, laquelle est adaptée pour alimenter un signal de mesure dans le réseau d'alimentation à mesurer,
• sachant que dans la phase de mesure l'unité d'accumulation d'énergie est agencée pour ne percevoir aucune énergie du réseau d'alimentation à mesurer,
**caractérisé en ce que**
• le signal de mesure est à large bande et l'impédance fonction de la fréquence est déterminée à large bande en se basant sur le signal de mesure, **en ce que**
• le signal de mesure comporte des composants fréquentiels de plus de 24,42 Hz aussi bien **en ce que**
• le signal de mesure comporte des composants fréquentiels de moins de 50 kHz,
• sachant que le dispositif est un dispositif « Prêt à l'emploi » [Plug & Play]
• sachant que le dispositif peut être connecté sans interruption à un réseau courant et une mesure peut être également pratiquée sur le réseau courant.

2. Dispositif (1) selon la revendication 1, **caractérisé en ce que** le signal de mesure à large bande comporte un signal binaire, lequel se rapproche du spectre d'un bruit blanc.

3. Dispositif (1) selon la revendication 1 ou 2, **caractérisé en ce que** le signal de mesure à large bande comporte un signal binaire, qui est produit par un générateur aléatoire déterministe.

4. Dispositif (1) selon l'une quelconque des revendications précédentes, **caractérisé en ce que** la phase de mesure est de 40 ms ou moins.

5. Dispositif (1) selon l'une quelconque des revendications précédentes, **caractérisé en ce que** le dispositif comporte en plus une unité d'évaluation qui est adaptée pour dériver un critère de stabilité à partir de l'impédance mesurée fonction de la fréquence.

6. Dispositif (1) selon l'une quelconque des revendications précédentes, **caractérisé en ce que** le dispositif comporte en plus une unité de télécommunication, qui est adaptée pour mettre à dispositions des données, lesquelles sont basées sur l'impédance déterminée fonction de la fréquence ou l'impédance elle-même.
